# EUROPÄISCHE PATENTSCHRIFT

(11) **EP 3 071 725 B1**
(45) Veröffentlichungstag und Bekanntmachung des Hinweises auf die Patenterteilung: **09.01.2019**
(21) Anmeldenummer: 14798894.3
(22) Anmeldetag: 17.11.2014
(51) Int. Cl.: C23C 14/02, C30B 23/02, C30B 29/40

(54) **VERFAHREN ZUR HERSTELLUNG EINES VERBUNDKÖRPERS MIT ZUMINDEST EINER FUNKTIONELLEN SCHICHT ODER ZUR WEITEREN HERSTELLUNG ELEKTRONISCHER ODER OPTO-ELEKTRONISCHER BAUELEMENTE**
METHOD FOR PRODUCING A COMPOSITE BODY HAVING AT LEAST ONE FUNCTIONAL LAYER, OR FOR FURTHER PRODUCTION OF ELECTRONIC OR OPTO-ELECTRONIC COMPONENTS
PROCÉDÉ DE PRODUCTION D'UN CORPS COMPOSITE COMPORTANT AU MOINS UNE COUCHE FONCTIONNELLE OU DE PRODUCTION ULTÉRIEURE D'UN COMPOSANT ÉLECTRONIQUE OU OPTOÉLECTRONIQUE

(30) Priorität: 19.11.2013 DE 102013112785
(43) Veröffentlichungstag der Anmeldung: 28.09.2016
(73) Patentinhaber: Aixatech GmbH, 52499 Baesweiler (DE)
(72) Erfinder: DIKME, Yilmaz, 52499 Baesweiler (DE)
(74) Vertreter: Michalski Hüttermann & Partner Patentanwälte mbB
(86) Internationale Anmeldenummer: PCT/EP2014/074739
(87) Internationale Veröffentlichungsnummer: WO 2015/074989

(56) Entgegenhaltungen:
- US-A- 5 900 126
- US-A1- 2004 200 576
- US-A1- 2008 182 426
- US-A1- 2012 125 765

## Beschreibung

Die vorliegende Erfindung betrifft ein Verfahren zur Herstellung eines als Schichtstruktur ausgebildeten Verbundkörpers mit zumindest einer funktionellen Schicht oder zur weiteren Verwendung zur Herstellung eines elektronischen oder opto-elektronischen Bauelements, mit zumindest einem als Platte ausgebildeten und zumindest eine ebene Substratoberfläche aufweisenden Substrat und mit zumindest einer im Wesentlichen polykristallinen oder zumindest einer im Wesentlichen einkristallinen Schicht, die zumindest einen Verbindungshalbleiter, einen keramischen Werkstoff oder einen metallischen Hartstoff umfasst. Die Erfindung betrifft weiterhin die Verwendung eines derart hergestellten Verbundkörpers zur Herstellung eines elektronischen oder opto-elektronischen Bauelements nach Anspruch 9.

### Stand der Technik

Zur Herstellung von elektronischen oder opto-elektronischen Bauelementen sind im Stand der Technik verschiedenste Verfahren bekannt. Beispielsweise findet das Verfahren der metallorganischen chemischen Gasphasenabscheidung (metal-organic chemical vapour deposition, MOCVD) bei der Herstellung von Leuchtdioden (LED) oder Laserdioden breite Anwendung. Bei Schichtstrukturen auf der Basis von Galliumnitrid (GaN) liegt die Prozesstemperatur für das MOCVD-Verfahren typischerweise oberhalb von 1000°C. Dabei werden überwiegend Saphir und auch Silizium und Siliziumkarbid als Substrat verwendet. Das Aufwachsen von GaN-basierten Schichten auf Fremdsubstrate (Heteroepitaxie) setzt eine Reinigung des Substrates bei hohen Temperaturen voraus und wird gefolgt von einer Haft- oder Nukleationsschicht, bevor die eigentliche Schichtstruktur (LED oder Transistor) folgt. Diese Schritte sind essentiell für das qualitative und reproduzierbare Wachstum der Schichten und benötigen ca. 20-30% der gesamten Prozessdauer. Damit beim Reinigen der Substrate bei hohen Temperaturen das Substrat nicht von ausgasenden Materialien der unbeabsichtigten Reaktormitbeschichtung des vorherigen Prozesses parasitär beschichtet wird, müssen vor dem Laden eines Substrats in den Prozessraum der MOCVD-Anlage die erforderlichen Reinheitsanforderungen erfüllt sein. Dies geschieht im derzeitigen Stand der Technik durch ein Austauschen der beschichteten Vorrichtung mit einer gereinigten Reaktorvorrichtung oder durch Erhitzen auf eine zur Reinigung der Reaktorvorrichtung geeignete Temperatur.

Beispielsweise beschreibt die Offenlegungsschrift DE 197 15 572 A1 ein Verfahren zum Herstellen von epitaktischen Schichten eines nitridischen Verbindungshalbleiters des III-V Typs der Struktur InₓAl_{y}Ga_{1-x-y}N (0 ≤ x, 0 ≤ y, x + y ≤ 1) auf einem Substrat aus einkristallinem Silizium beschrieben. Das Verfahren weist Verfahrensschritte auf, in denen auf der Oberfläche eines Substrates aus einkristallinem Silizium eine parzellenartige Struktur erzeugt wird. In den Parzellen liegt die Siliziumoberfläche frei und die Ränder der Parzellen sind von einem Maskierungsmaterial umgeben. Durch epitaktisches Wachstum des nitridischen Verbindungshalbleiters ausschließlich in den Parzellen auf der Siliziumoberfläche werden lokale Inseln erzeugt, an deren Ränder sich die durch die Gitterfehlanpassung erzeugten Verspannungen abbauen können. In bzw. auf den Parzellen werden schließlich Bauelemente hergestellt.

Die europäische Patentanmeldung EP 1 816 672 A1 schlägt ein Verfahren zur Herstellung von Substraten zur spannungs- und rissfreien Abscheidung von Halbleitermaterialien vor, in dem ein Substrat aus Halbleitermaterial bereitgestellt wird, eine Schicht aus einem zweiten Halbleitermaterial auf dieses Substrat zur Erzeugung einer Halbleiterschichtstruktur aufgebracht wird, leichte Gasionen in die Halbleiterschichtstruktur zur Erzeugung einer Hohlräume beinhaltenden Schicht innerhalb der Halbleiterschichtstruktur implantiert werden, diese Hohlräume durch Fremdatome einer bestimmten Spezies stabilisiert werden und wenigstens eine epitaktische Schicht auf die Halbleiterschichtstruktur aufgebracht wird. Auf diese Weise kann ein Aufreißen einer mit angeschlossenen Hochtemperaturprozessen wie MOCVD mit Temperaturen von größer oder gleich 1000°C abgeschiedenen Schicht vermeidbar sein.

Zudem ist aus der Offenlegungsschrift DE 31 36 515 A1 ein Verfahren zur Zerstäubung eines Elements mittels einer von einem Magnetron gebildeten Plasmaquelle bekannt, wobei das Plasma zwischen zwei Flächen der Quelle erzeugt wird, die ein elektrostatisches Feld bilden, und eine Generatoranode, die angrenzend an das Plasma angebracht ist, das Plasma gegen das zu zerstäubende Element ausstößt. Es werden verschiedene Anwendungsmöglichkeiten beschrieben, so das selektive Beschichten von Substraten unterschiedlicher elektrischer Leitfähigkeit, das Reinigen von Substraten, das Ionenfräsen, die Wiedergewinnung teurer oder gefährlicher Beschichtungsmaterialien, das Heizen mit geringem Verlust in der Heizquelle, das Zerstäuben mit reaktionsfähigen Ionen, die Sensibilisierung oder die Ladungsneutralisierung sowie das Pumpen aktiver Gase.

Die US-Patentschrift US 5,900,126 A beschreibt ein Verfahren zur Herstellung eines als Schichtstruktur ausgebildeten Verbundkörpers mit zumindest einer funktionellen Schicht, mit zumindest einem als Platte ausgebildeten Substrat, welches zumindest eine ebene Substratoberfläche aufweist, und mit zumindest einer im Wesentlichen polykristallinen Schicht, die zumindest einen metallischen Hartstoff umfasst, wobei das Verfahren die folgenden Schritte umfasst: (i) Bearbeiten der Substratoberfläche durch Zuführen von Wasserstoff aus einer Materialquelle und einem eigens dafür hergestellten Plasma; (ii) Terminieren der Substratoberfläche durch Aufbringen von Kohlenstoff, und/oder Stickstoff aus der Materialquelle oder einer anderen Materialquelle und einem eigens dafür hergestellten Plasma bis in eine Tiefe von einigen Mikrometern; und (iii) Aufwachsen der zumindest einen Schicht durch Zuführen von Materialkomponenten des metallischen Hartstoffs aus Materialquellen zu der zumindest einen ebenen Substratoberfläche.

Die US-Patentanmeldung US 2008/182426 A1 beschreibt ebenfalls ein Verfahren zur Herstellung eines als Schichtstruktur ausgebildeten Verbundkörpers mit zumindest einer funktionellen Schicht, mit zumindest einem als Platte ausgebildeten Substrat, welches zumindest eine ebene Substratoberfläche umfasst, und mit zumindest einer im Wesentlichen polykristallinen oder zumindest einer im Wesentlichen einkristallinen Schicht, die zumindest einen Verbindungshalbleiter umfasst, wobei das Verfahren die folgenden Schritte umfasst:(i) Erwärmung zumindest eines Teils der ebenen Substratoberfläche auf eine Temperatur von höchstens 300°C; (ii) Terminieren der Substratoberfläche durch Aufbringen von Stickstoff aus der Materialquelle oder einer anderen Materialquelle und einem eigens dafür hergestellten Plasma, und (iii) Aufwachsen der zumindest einen Schicht durch Zuführen von Materialkomponenten des Verbindungshalbleiters aus Materialquellen zu der zumindest einen ebenen Substratoberfläche.

### Offenbarung der Erfindung

Es ist eine Aufgabe der vorliegenden Erfindung, ein Verfahren bereitzustellen, das Verbesserungen hinsichtlich des Aufwands zur Bereitstellung der Prozessbedingungen und/oder der Prozessvorrichtung aufweist. Weiterhin ist es Aufgabe der vorliegenden Erfindung, eine Verwendung für einen durch dieses Verfahren herstellbaren Verbundkörper, einen derartigen Verbundkörper und ein elektronisches oder opto-elektronisches Bauelement mit einem derartigen Verbundkörper anzugeben.

Die Aufgabe wird gelöst durch die Gegenstände der unabhängigen Ansprüche 1, 9, 12 und 13. Bevorzugte Ausgestaltungen der Erfindung sind in den Unteransprüchen angegeben.

Gegenstand der vorliegenden Erfindung ist ein Verfahren zur Herstellung eines Verbundkörpers mit zumindest einer funktionellen Schicht oder zur weiteren Verwendung zur Herstellung eines elektronischen oder opto-elektronischen Bauelements, der Verbundkörper als Schichtstruktur ausgebildet und umfassend:
- zumindest ein als Platte ausgebildetes Substrat mit zumindest einer ebenen Substratoberfläche und
- zumindest eine im Wesentlichen polykristalline oder zumindest eine im Wesentlichen einkristalline Schicht, die zumindest einen Verbindungshalbleiter, einen keramischen Werkstoff oder einen metallischen Hartstoff umfasst.

Unter einer "funktionellen Schicht" soll in diesem Zusammenhang insbesondere eine Schicht verstanden werden, die dazu geeignet ist, hinsichtlich einer elektrischen oder optischen Anwendung aufgrund einer elektrischen oder optischen Eigenschaft eine spezifizierte Funktion auszuüben.

Unter dem Begriff "elektronisches oder opto-elektronisches Bauelement" sollen insbesondere photovoltaische Bauelemente, wie etwa Solarzellen, Bauelemente zur Verwendung in der Leistungselektronik, wie etwa Leistungstransistoren (IG-BTs), Thyristoren etc., Bauelemente zur Verwendung in der Hochfrequenztechnik, beispielsweise HEMTs (high electron-mobility transistor) sowie Leucht- und Laserdioden verstanden werden.

Unter "im Wesentlichen" soll in diesem Zusammenhang insbesondere ein Anteil von mehr als 50% verstanden werden. Insbesondere soll auch ein Anteil von 100% eingeschlossen sein.

Das Verfahren umfasst folgende Schritte:
- Erwärmung zumindest eines Teils der ebenen Substratoberfläche auf eine Temperatur von mindestens 100°C und höchstens 550°C;
- Reinigen der Substratoberfläche durch Zuführen von Wasserstoff aus einer ersten Materialquelle und einem eigens dafür hergestellten Plasma;
- Terminieren der Substratoberfläche durch Aufbringen von Kohlenstoff, Stickstoff oder Sauerstoff aus der ersten Materialquelle oder einer zweiten Materialquelle und einem eigens dafür hergestellten Plasma; und
- Aufwachsen der zumindest einen Schicht durch Zuführen von Materialkomponenten des Verbindungshalbleiters, des keramischen Werkstoffs oder des metallischen Hartstoffs aus der ersten Materialquelle und der zweiten Materialquelle zu der zumindest einen ebenen Substratoberfläche.

Der Begriff "Verbindungshalbleiter" soll in diesem Zusammenhang insbesondere Verbindungen mit Halbleitereigenschaften beinhalten, die von
- Verbindungen von Elementen der II. Hauptgruppe mit Elementen der VI. Hauptgruppe des Periodensystems der Elemente (PSE),
- Verbindungen von Elementen der III. Hauptgruppe mit Elementen der V. Hauptgruppe,
- Verbindungen von Elementen der III. Hauptgruppe mit Elementen der VI. Hauptgruppe
- Verbindungen von Elementen der I. Hauptgruppe mit Elementen der III. Hauptgruppe und Elementen der VI. Hauptgruppe,
- Verbindungen von Elementen der III. Hauptgruppe mit Elementen der VI. Hauptgruppe sowie
- Verbindungen unterschiedlicher Elemente der IV. Hauptgruppe des PSE gebildet sind.

Unter einem "metallischen Hartstoff" soll in diesem Zusammenhang insbesondere eine Schicht mit einer Vickers-Härte von mehr als 1000 VH und/oder einer Mohshärte von mehr als 9,0 verstanden werden, die einen überwiegenden Anteil von metallischen Bindungen aufweist. Ein Beispiel für einen solchen metallischen Hartstoff ist Titannitrid (TiN).

Der Begriff "keramischer Werkstoff" soll in diesem Zusammenhang insbesondere nichtoxidische Keramikwerkstoffe umfassen. Beispiele für solche keramischen Werkstoffe sind Siliziumnitrid (Si₃N₄) und Borcarbid (B₄C).

Unter "Terminieren der Substratoberfläche" soll in diesem Zusammenhang insbesondere eine Umwandlung des Substrats in den obersten bis zu fünf Monolagen der Substratoberfläche verstanden werden.

Das Terminieren der Substratoberfläche durch Aufbringen von Stickstoff (Nitridieren) kann im Wesentlichen mit Stickstoff, mit oder ohne Anteile von Argon und/oder Helium, oder mit Stickstoffverbindungen, mit oder ohne Anteile von Argon und/oder Helium, erfolgen.

Das Terminieren der Substratoberfläche durch Aufbringen von Sauerstoff (Oxidieren) kann im Wesentlichen mit Sauerstoff, mit oder ohne Anteile von Argon und/oder Helium, oder mit Sauerstoffverbindungen, mit oder ohne Anteile von Argon und/oder Helium, erfolgen.

Das Terminieren der Substratoberfläche durch Aufbringen von Kohlenstoff (Karbonisieren) kann im Wesentlichen mit Kohlenstoff, mit oder ohne Anteile von Argon und/oder Helium, oder mit Kohlenstoffverbindungen, mit oder ohne Anteile von Argon und/oder Helium, erfolgen.

In einer Ausführungsform kann das als Platte ausgebildete Substrat einkristallin ausgestaltet sein und beispielsweise Saphir, Silizium, Lithiumaluminat, Siliziumkarbid, Galliumnitrid, Galliumarsenid, Germanium oder Zirkoniumdiboronid umfassen. In einer anderen Ausführungsform kann das Substrat auch polykristallin oder amorph ausgestaltet sein und beispielsweise Glas, Poly-Silizium, Folien, Kunststoffe, Papier, Keramik und metallische Wafer, wie zum Beispiel Wolframkupfer, umfassen.

Bei dem genannten Verfahren ist die Prozesstemperatur gegenüber dem bekannten Stand der Technik deutlich reduziert. Dadurch können Prozesslaufzeiten zur Herstellung des Verbundkörpers verkürzt und der notwendige Energie- und Kostenaufwand verringert werden. Weiterhin können durch die im Vergleich zum Stand der Technik herabgesetzte Temperatur bei der Herstellung auftretende thermische Spannungen reduziert werden, wodurch die Qualität und Haltbarkeit des Verbundkörpers erhöht werden können.

Insbesondere vorteilhaft ist die Erwärmung eines Teils der ebenen Substratoberfläche auf eine Temperatur von mindestens 100°C und höchstens 300°C, wenn die zumindest eine einen Verbindungshalbleiter umfassende Schicht im Wesentlichen polykristallin ist. Hingegen ist die Erwärmung eines Teils der ebenen Substratoberfläche auf eine Temperatur von mindestens 100°C und höchstens 550°C vorteilhaft, wenn die zumindest eine einen Verbindungshalbleiter umfassende Schicht im Wesentlichen einkristallin ist.

In einer vorteilhaften Ausgestaltung des Verfahrens erfolgt das Zuführen der Komponenten des Verbindungshalbleiters, des keramischen Werkstoffs oder des metallischen Hartstoffs mittels Kathodenzerstäubung, plasmaunterstützter chemischer Gasphasenabscheidung PECVD oder mittels zumindest einer lonenkanone. Dadurch kann die zumindest eine, zumindest einen Verbindungshalbleiter umfassende Schicht zuverlässig und reproduzierbar hergestellt werden. Unter einer "Ionenkanone" soll in diesem Zusammenhang insbesondere eine Vorrichtung verstanden werden, in der Material ionisiert und mittels einer Beschleunigungsspannung gerichtet beschleunigt wird.

Das aus den Materialquellen zugeführte Material kann als Festkörper im Wesentlichen in Reinform, in metall-organischer Form oder als Legierung vorliegen, das verdampft, gesputtert oder erhitzt über ein Trägergas eingeleitet werden kann. Es kann auch als Gas oder Gasverbindung vorliegen, die erhitzt über ein Trägergas eingeleitet werden kann. Das Material kann ferner als flüssige Verbindung, in metall-organischer Form oder als Legierung vorliegen, die verdampft, gesputtert oder erhitzt über ein Trägergas eingeleitet werden.

Mit besonderem Vorteil erfolgt das Zuführen der Komponenten des Verbindungshalbleiters, des keramischen Werkstoffs oder des metallischen Hartstoffs mittels einer Streifenquelle. Die Streifenquelle kann beispielsweise
- aus einem Streifen-Element bestehen, durch das alle Quellmaterialien, die zum Zuführen der Komponenten des Verbindungshalbleiters, des keramischen Werkstoffs oder des metallischen Hartstoffs benötigt werden, gemeinsam geleitet werden;
- mehrere Streifen-Elemente umfassen, durch das alle benötigen Quellmaterialien einzeln oder in kleineren Gruppen zusammengefasst geleitet werden;
- als Streifenmagnetron-Quelle ausgebildet sein;
- als Rohrmagnetron-Quelle ausgebildet sein;
- als Streifenverdampfer ausgebildet sein;
- mehrere Verdampferstationen umfassen, die zusammen einen Streifen bilden;
- mehrere lonenkanonen umfassen, die zusammen einen Streifen bilden
- als Streifen-Ionenkanone ausgebildet sein;
- eine Streifenmaske aufweisen, die mit einem oder mehreren Schlitzen ausgestattet ist, durch den oder durch die die benötigten Quellenmaterialien austreten; oder
- eine Streifenmaske aufweisen, die einen Siebeinlass umfasst, durch den die benötigten Quellenmaterialien austreten.

Durch die Verwendung der Streifenquelle kann die zumindest eine, zumindest einen Verbindungshalbleiter umfassende Schicht in besonders kurzer Prozesszeit und besonders gleichmäßig hergestellt werden.

Weiterhin wird vorgeschlagen, dass das Zuführen der Komponenten des Verbindungshalbleiters, des keramischen Werkstoffs oder des metallischen Hartstoffs mittels zumindest zweier unterschiedlicher Streifenquellen erfolgt, von denen zumindest eine Streifenquelle eine lonenkanone umfasst. Dadurch kann die zumindest eine, zumindest einen Verbindungshalbleiter umfassende Schicht im Hinblick auf Betriebsbedingungen auf eine besonders flexible Weise hergestellt werden.

In einer weiteren vorteilhaften Ausgestaltung des Verfahrens wird das Substrat zumindest während der Durchführung der Schritte des Terminierens und des Aufwachsens relativ zu zumindest einer der Materialquellen bewegt. Dadurch können besonders gleichmäßige Schichtdicken der zumindest einen Schicht, die zumindest einen Verbindungshalbleiter umfasst, erzielt werden.

Wenn die Schritte des Verfahrens in zumindest zwei unterschiedlichen vakuumfähigen Reaktoren ausgeführt werden, wobei die Reaktoren durch Vakuumschleusen miteinander verbunden sind, kann vorteilhaft eine besonders hohe Durchsatzrate bei der Herstellung der Verbundkörper erreicht werden. Unter einem "vakuumfähigen Reaktor" soll in diesem Zusammenhang insbesondere eine Kammer verstanden werden, in der mittels einer geeigneten Pumpvorrichtung ein Vakuum mit einem Gasdruck in einem Bereich zwischen 0.1 Pa und 10⁻⁵ Pa (1 Pa =̂ 1 N/m²) erreichbar ist. Dabei liegt ein Arbeitsdruck in einem Betrieb des Reaktors oberhalb von 0.1 Pa, nämlich zwischen 0.1 Pa und 10 Pa.

Ein weiterer Aspekt der Erfindung ist ein Verfahren zur Herstellung eines elektronischen oder opto-elektronischen Bauelements durch Aufbringen einer Mehrzahl von Halbleiter umfassenden Schichten auf einen Verbundkörper, der gemäß einer Ausführungsform der zuvor offenbarten Verfahren oder einer Kombination davon hergestellt wurde. Dabei weist das Verfahren die gleichen Vorteile hinsichtlich einer verkürzten Prozesslaufzeit, einem verringertem Energie- und Kostenaufwand und reduzierter bei der Herstellung auftretender thermischer Spannungen auf wie das Verfahren zur Herstellung des Verbundkörpers.
Dabei kann der Verbundkörper mit der zumindest einen, zumindest eine Verbindungshalbleiter umfassenden Schicht nach dessen Herstellung direkt dem Verfahren zur Herstellung eines elektronischen oder opto-elektronischen Bauelements unterzogen werden. Der Verbundkörper kann nach dessen Herstellung aber auch zu einer anderen Herstellungsanlage, insbesondere einer MOCVD-Anlage, verbracht werden, um damit das elektronische oder opto-elektronische Bauelement herzustellen.

In einer vorteilhaften, weitergestalteten Ausführungsform des Verfahrens umfasst die Mehrzahl von Halbleiter umfassenden Schichten Zwischenschichten ("interlayers"), die zur Verringerung von mechanischen Spannungen innerhalb des Verbundkörpers dienen. Dabei können die Zwischenschichten beispielsweise in einer dem Fachmann bekannten Art als Gradientenschicht zwischen zwei unterschiedliche Halbleiter umfassende Schichten, als Schichten, die im Vergleich zu zwei unterschiedliche Halbleiter umfassenden Schichten dünner ausgestaltet sind und abwechselnd jeweils einen der zwei unterschiedlichen Halbleiter umfassen, oder als Schichten ausgeführt sein, die bei einer abweichenden Prozesstemperatur hergestellt werden.

Ein weiterer Aspekt der Erfindung ist die Verwendung des gemäß einer Ausführungsform der zuvor offenbarten Verfahren oder einer Kombination davon hergestellten Verbundkörpers zur Herstellung eines elektronischen oder opto-elektronischen Bauelements durch Aufbringen einer Mehrzahl Halbleiter umfassender Schichten auf den Verbundkörper.

Dies ist insbesondere dann von Vorteil, wenn die Herstellungsanlage zur Herstellung des elektronischen oder opto-elektronischen Bauelements, die insbesondere als MOCVD-Anlage, als Molekularstrahlepitaxie (MBE)-Anlage oder als Hydridgasphasenepitaxie (HVPE)-Anlage ausgebildet sein kann, wesentlich komplexer ausgestaltet und somit sowohl in der Anschaffung als auch hinsichtlich der Betriebskosten teurer ist als die Herstellungsanlage zur Herstellung des Verbundkörpers. Die Terminierung der Substratoberfläche und deren Beschichtung mit einer Startschicht kann den Transport des Verbundkörpers ohne Vakuumbedingungen sowie die Herstellung des elektronischen oder opto-elektronischen Bauelements in der dazu vorgesehen Herstellungsanlage ohne vorbereitende Reinigung oder Aufbringung einer Startschicht ermöglichen, so dass die Verbundkörper auch auf Vorrat hergestellt werden und zur Herstellungsanlage zur Herstellung des elektronischen oder opto-elektronischen Bauelements transportiert werden können.

Von besonderem Vorteil ist eine weitergestaltete Verwendung des gemäß einer Ausführungsform der zuvor offenbarten Verfahren oder einer Kombination davon hergestellten Verbundkörpers zur Herstellung eines elektronischen oder opto-elektronischen Bauelements, wenn die Mehrzahl von Schichten Zwischenschichten umfasst, die zur Verringerung von mechanischen Spannungen innerhalb des Verbundkörpers dienen. Die Zwischenschichten können in der zuvor beschriebenen, dem Fachmann bekannten Weise ausgestaltet sein.

Die gemäß einer Ausführungsform der zuvor offenbarten Verfahren oder einer Kombination davon hergestellten Verbundkörper können besonders vorteilhaft zur Herstellung eines elektronischen oder opto-elektronischen Bauelements verwendet werden, wenn das Aufbringen der Mehrzahl Halbleiter umfassender Schichten durch ein Verfahren erfolgt, dass aus einer Gruppe ausgewählt ist, die von metallorganischer chemischer Gasphasenabscheidung MOCVD, Molekularstrahlepitaxie MBE, oder Hydridgasphasenepitaxie HVPE ausgewählt ist.

### Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
Fig. 1 eine schematische, perspektivische Darstellung eines Verbundkörpers, der mit einem erfindungsgemäßen Verfahren herstellbar ist,
Fign. 2a-2c schematische Darstellungen von elektronischen und opto-elektronischen Bauelementen, die unter Verwendung von Verbundkörpern fertigbar sind, die mit einem erfindungsgemäßen Verfahren herstellbar sind,
Fig. 3a-d mehrere Ausführungsformen von Zwischenschichten (interlayers),
Fig. 4 eine schematische Darstellung eines Komplettsystems zur Durchführung des erfindungsgemäßen Verfahrens zur Herstellung eines Verbundkörpers gemäß der Fig. 1,
Fig. 5 eine alternative Ausführungsform eines Komplettsystems zur Durchführung des erfindungsgemäßen Verfahrens zur Herstellung eines Verbundkörpers gemäß der Fig. 1, und
Fig. 6 eine schematische Darstellung eines Reaktors der Komplettsysteme gemäß den Figuren 4 und 5 zur Durchführung des erfindungsgemäßen Verfahrens.

### Beschreibung der Ausführungsbeispiele

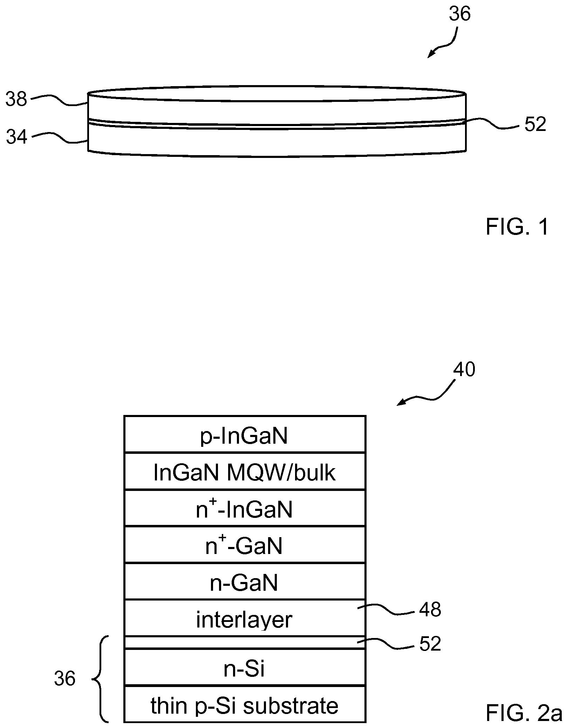

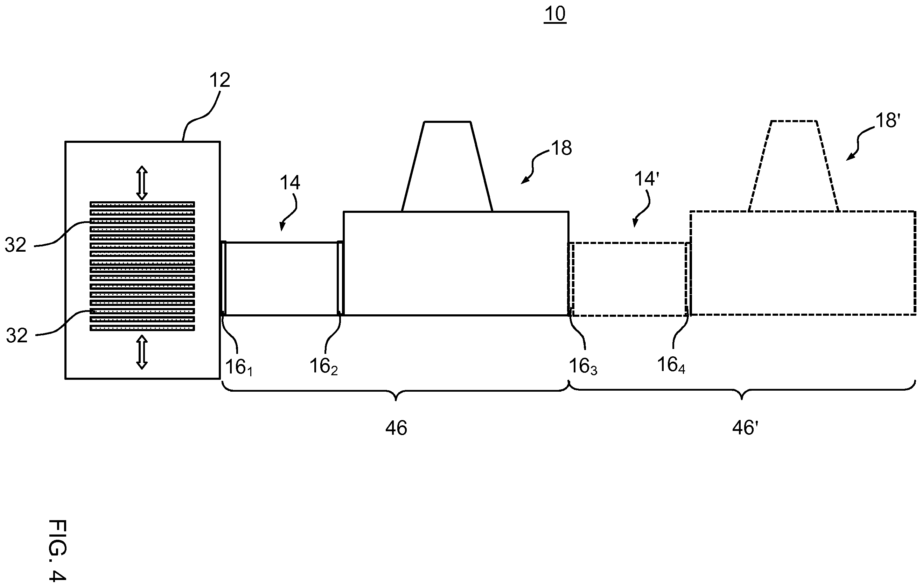

Fig. 4 zeigt eine schematische Darstellung eines Komplettsystems 10 zur Durchführung des erfindungsgemäßen Verfahrens zur Herstellung eines als Schichtstruktur ausgebildeten Verbundkörpers 36 (Fig. 1). Das Komplettsystem 10 weist eine Be- und Endladekammer 12, eine Übergabekammer 14 und einen Reaktor 18 auf. In der Be- und Endladekammer 12, in der während des Be- und Entladens normaler Umgebungsluftdruck herrscht, können eine Vielzahl von Waferplatten 32, in diesem konkreten Ausführungsbeispiel sechzehn Waferplatten 32, vertikal beabstandet gehaltert werden, die jeweils zumindest ein als Platte ausgebildetes Substrat 34 mit einer ebenen Substratoberfläche beinhalten. Die Übergabekammer 14 ist mit einer ihrer Stirnseiten mit der Be- und Entladekammer 12 und mit der anderen Stirnseite mit dem Reaktor 18 verbunden. Die Übergabekammer 14 weist an jeder ihrer beiden Stirnseiten eine Durchgangsöffnung auf, die größenmäßig für einen Durchgang einer Waferplatte 32 ausgelegt ist, und ist beidseitig mit jeweils einer Vakuumschleuse 16₁, 16₂ ausgestattet.

Prinzipiell kann das Komplettsystem 10 auch ohne Übergabekammer 14 ausgestaltet werden, insbesondere dann, wenn keine Gefahr durch Querkontamination besteht.

Die Be-und Entladekammer 12 sowie der Reaktor 18 weisen an einer der Übergabekammer 14 zugewandten Seite ebenfalls eine Durchgangsöffnung auf, die größenmäßig für einen Durchgang einer Waferplatte 32 ausgelegt ist. Die Übergabekammer 14 ist mit einem Transportsystem (nicht dargestellt) ausgestattet, das dazu vorgesehen ist, zur Herstellung eines Verbundkörpers 36 eine der Waferplatten 32 durch die der Be- und Entladekammer 12 zugewandten Durchgangsöffnung durch die Übergabekammer 14 zu der dem Reaktor 18 zugewandten Durchgangsöffnung zu transportieren und an ein Transportsystem des Reaktors 18 zu übergeben. Weiterhin ist das Transportsystem der Übergabekammer 14 dazu vorgesehen, nach einer Herstellung des Verbundkörpers 36 im Reaktor 18 die Waferplatte 32 an der dem Reaktor 18 zugewandten Durchgangsöffnung entgegenzunehmen, durch die Übergabekammer 14 zu der der Be- und Entladekammer 12 zugewandten Durchgangsöffnung zu transportieren und in der Be-und Entladekammer 12 abzulegen.

Die Übergabekammer 14 und deren Vakuumschleusen 16₁, 16₂ sowie der Reaktor 18 und die Be- und Entladekammer 12 sind vakuumfähig und können mittels einer geeigneten Pumpvorrichtung (nicht dargestellt) auf einen Gasdruck in einem Bereich zwischen 0.1 Pa und 10⁻⁵ Pa evakuiert werden, wobei ein Arbeitsdruck im Betriebszustand des Reaktors 18 auch oberhalb von 0.1 Pa, etwa bis zu 10 Pa, liegen kann.

Das Komplettsystem 10 gemäß der Fig. 4 ist durch Hinzufügen einer oder mehrerer weiterer Einheiten 46' (gestrichelt dargestellt), die eine Übergabekammer 14' und einen in der oben beschriebenen Weise mit der Übergabekammer 14' verbundenen Reaktor 18' beinhalten, ausbaufähig, so dass Schritte des Herstellungsverfahrens in zumindest zwei unterschiedlichen vakuumfähigen Reaktoren 18, 18' ausgeführt werden könnten, wobei die Reaktoren 18, 18' durch Vakuumschleusen 16₃, 16₄ miteinander verbunden sind.

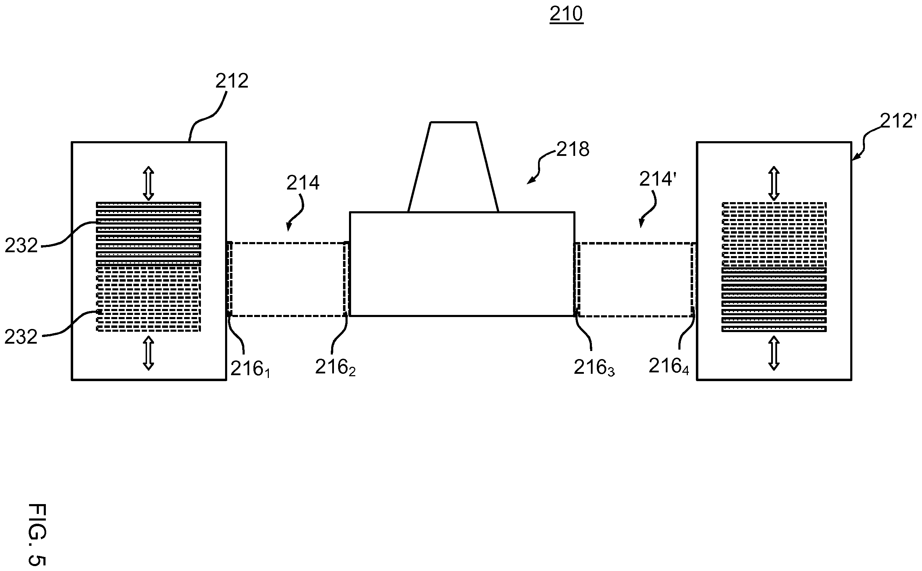

Eine alternative Ausgestaltung eines Komplettsystems ist in der Fig. 5 dargestellt. Zur Unterscheidung von dem Komplettsystem 10 gemäß der Fig. 4 wurde allen Bezugszeichen dieser Ausführungsform die Ziffer 2 vorangestellt. In einer derartigen Ausführung ist das Komplettsystem 210 besonders vorteilhaft mit einer zweiten Be- und Endladekammer 212' ausgerüstet, die über eine zusätzliche Übergabekammer 214' mit dem Reaktor 218' verbunden ist, wobei die erste Be-und Endladekammer 212 beispielsweise ausschließlich als Beladekammer und die zweite Be- und Endladekammer 212' ausschließlich als Endladekammer dient, und wobei in der zusätzlichen Übergabekammer 214' ebenfalls eines der beschriebenen Transportsysteme installiert ist. Auf diese Weise kann ein besonders effizienter, durch die Waferplatten 232 gebildeter Materialfluss durch das Komplettsystem 210 erreicht werden, wobei für den Fachmann leicht ersichtlich ist, dass eine Richtung des Materialflusses durch geeignete Maßnahmen auch in der entgegengesetzten Richtung möglich ist. Wie im Ausführungsbeispiel gemäß der Fig. 4 sind die Übergabekammern 214, 214' des Komplettsystems 210 bei geringer Gefahr durch Querkontamination fakultativ.

Das Komplettsystem 10 gemäß der Fig. 4 ist durch Hinzufügen einer oder mehrerer weiterer Einheiten 46' (gestrichelt dargestellt), die eine Übergabekammer 14' und einen in der oben beschriebenen Weise mit der Übergabekammer 14' verbundenen Reaktor 18' beinhalten, ausbaufähig, so dass Schritte des Herstellungsverfahrens in zumindest zwei unterschiedlichen vakuumfähigen Reaktoren 18, 18' ausgeführt werden könnten, wobei die Reaktoren 18, 18' durch Vakuumschleusen 163, 164 miteinander verbunden sind.

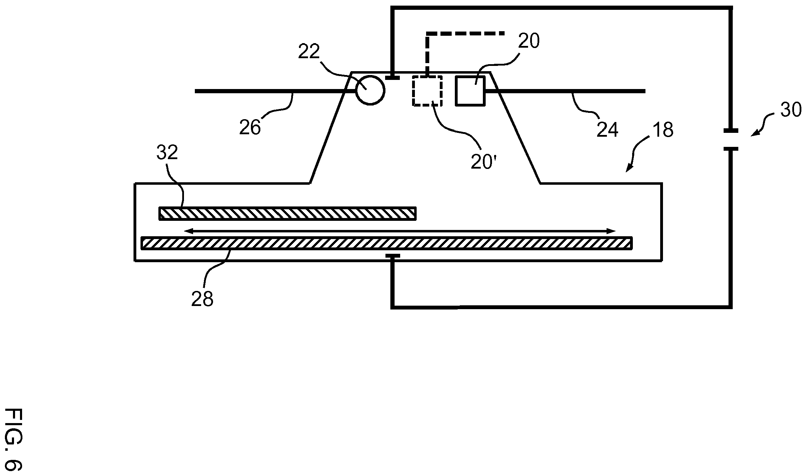

Eine schematische Darstellung des Reaktors 18 des Komplettsystems 10 ist in Fig. 6 gezeigt. Innerhalb des Reaktors 18 sind in einem oberen Bereich eine erste Materialquelle 20 und eine zweite Materialquelle 22 nebeneinander angeordnet. Prinzipiell kann der Reaktor 18 auch noch weitere Materialquellen beinhalten. Eine solche weitere Materialquelle 20' ist in der Fig. 6 in gestrichelter Linie dargestellt.

Die erste Materialquelle 20 ist als Streifen-Ionenkanone als eine erste Streifenquelle mit einer ersten Erstreckungsrichtung eines Streifens ausgebildet. Über erste Gasleitungen 24 kann der ersten Materialquelle 20 Gas (Argongas und/oder Sauerstoffgas und/oder Stickstoffgas und/oder Wasserstoffgas und/oder Methangas, usw.) zugeführt werden. Das Zuführen der ersten Komponente des Verbindungshalbleiters erfolgt während des Herstellungsvorgangs mittels der ersten Streifenquelle durch Aktivierung der Streifen-Ionenkanone.

Die zweite Materialquelle 22 ist als Rohrmagnetron oder Streifenmagnetron als eine zweite Streifenquelle mit einer zweiten Erstreckungsrichtung eines Streifens ausgebildet. Über zweite Gasleitungen 26 kann der zweiten Materialquelle 22 Gas (Argongas und/oder Sauerstoffgas und/oder Stickstoffgas und/oder Wasserstoffgas und/oder Methangas, usw.) zugeführt werden. Ein metallisches Target (nicht dargestellt), das eine zweite Komponente eines Verbindungshalbleiters umfasst, ist innerhalb des Rohrmagnetrons angeordnet. Das Zuführen der zweiten Komponente des Verbindungshalbleiters erfolgt während des Herstellungsvorgangs mittels der zweiten Streifenquelle durch Kathodenzerstäubung (Sputtern) durch Aktivierung des Rohrmagnetrons.

Somit erfolgt das Zuführen der Komponenten des Verbindungshalbleiters mittels zumindest zweier unterschiedlicher Streifenquellen, von denen eine Streifenquelle eine lonenkanone umfasst.

In der in Fig. 6 dargestellten Ausführungsform des Reaktors 18 sind die Materialquellen 20, 20', 22 und die Waferplatte 32 so angeordnet, dass das Zuführen der Komponenten des Verbindungshalbleiters in einer im Wesentlichen vertikalen Richtung von oben nach unten erfolgt. Für andere Anwendungen kann es jedoch auch sinnvoll sein, eine Anordnung zu wählen, bei der das Zuführen der Komponenten des Verbindungshalbleiters in einer im Wesentlichen seitlichen Richtung oder in einer im Wesentlichen vertikalen Richtung von unten nach oben erfolgt, wobei eine Anordnung der Materialquellen 20, 20', 22 und der Waferplatte 32 in einer entsprechenden Weise auszulegen ist.

Die erste Materialquelle 20 und die zweite Materialquelle 22 sind so angeordnet, dass die erste Erstreckungsrichtung und die zweite Erstreckungsrichtung im Wesentlichen parallel zueinander verlaufen und auf eine gemeinsame Linie ausgerichtet sind. Die gemeinsame Linie kann in der unmittelbaren Nähe der Oberfläche (Abstand geringer als 10 mm) der Waferplatte 32 angeordnet sein. In einer alternativen Ausgestaltung könnten die Materialquellen auch so ausgerichtet sein, dass die gemeinsame Linie von der Waferplatte 32 beabstandet (Abstand größer als 20 mm) verläuft.

In einem unteren Bereich des Reaktors 18 ist ein Transportsystem (nicht dargestellt) angeordnet, das dazu vorgesehen ist, die Waferplatte 32 relativ zu der ersten Materialquelle 20 und der zweiten Materialquelle 22 hin und her zu bewegen. Dabei ist die Bewegung im Wesentlichen translatorisch mit einer geringen Exzentrizität ausgelegt, wobei die translatorische Bewegung sowohl senkrecht als auch parallel zu der ersten Erstreckungsrichtung und der zweiten Erstreckungsrichtung ausführbar ist.

Unterhalb der Waferplatte 32 ist der Reaktor 18 mit einer Heizvorrichtung 28 ausgestattet, die bei Aktivierung die Waferplatte 32 auf eine Temperatur von maximal 550°C erwärmen kann. Prinzipiell kann die Heizvorrichtung 28 in einer alternativen Ausführung auch oberhalb der Waferplatte 32 angeordnet sein (nicht dargestellt), oder es können Heizvorrichtungen 28 oberhalb und unterhalb der Waferplatte 32 vorgesehen sein.

Der Reaktor 18 ist weiterhin mit einer Vorrichtung 30 zur Beschleunigung und/oder Anregung der zerstäubten Partikel (DC-bias oder RF-bias) ausgestattet.

Im Folgenden werden Schritte des Verfahrens zur Herstellung des Verbundkörpers 36 beschrieben. Dabei wird vorausgesetzt, dass sich die erste Materialquelle 20 und die zweite Materialquelle 22 und deren zugeordnete erste Gasleitungen 24 und zweite Gasleitungen 26 in einem betriebsbereiten Zustand befinden, der Gasdruck im Reaktor 18 sich im beschriebenen Arbeitsdruckbereich bewegt und die Waferplatte 32 im Transportsystem des Reaktors 18 gehaltert ist.

In einem ersten Schritt des Verfahrens wird die Waferplatte 32 mittels der Heizvorrichtung 28 auf eine Temperatur von mindestens 100°C und höchstens 550°C erwärmt.

In einem nächsten Schritt des Verfahrens erfolgt ein Reinigen der Substratoberfläche durch Zuführen von Wasserstoffgas aus den ersten Gasleitungen 24 der ersten Materialquelle 20 und einem eigens dafür hergestellten Plasma.

In einem anschließenden Schritt wird die Substratoberfläche durch Aufbringen von Kohlenstoff, Stickstoff oder Sauerstoff aus der zweiten Materialquelle 22 und einem eigens dafür hergestellten Plasma terminiert.

In einem nachfolgenden Schritt erfolgt das Aufwachsen der zumindest einen Schicht, die zumindest einen Verbindungshalbleiter, einen keramischen Werkstoff oder einen metallischen Hartstoff umfasst, durch Zuführen von Materialkomponenten des zumindest einen Verbindungshalbleiters, keramischen Werkstoffs oder metallischen Hartstoffs aus der ersten Materialquelle 20 und der zweiten Materialquelle 22 zu der zumindest einen ebenen Substratoberfläche.

Während der Durchführung der Schritte des Terminierens und des Aufwachsens wird die das als Platte ausgebildete Substrat 34 umfassende, ausgewählte Waferplatte 32 mittels des Transportsystems des Reaktors 18 relativ zu der ersten Materialquelle 20 und der zweiten Materialquelle 22 bewegt, wodurch eine besonders gleichmäßige Schichtdicke und Qualität der im Wesentlichen polykristallinen oder im Wesentlichen einkristallinen Schicht, die zumindest einen Verbindungshalbleiter umfasst, erreicht werden kann.

Fig. 1 zeigt eine schematische Darstellung des als Schichtstruktur ausgebildeten Verbundkörpers 36, der mit einem erfindungsgemäßen Verfahren hergestellt wurde, dessen Ausführungsform vorangehend beschrieben ist. Der Verbundkörper 36 umfasst das als Platte ausgebildete Substrat 34 mit der ebenen Substratoberfläche. Ferner beinhaltet der Verbundkörper 36 eine Terminierungsschicht 52 und zumindest eine im Wesentlichen polykristalline oder zumindest eine im Wesentlichen einkristalline Schicht 38, die zumindest einen Verbindungshalbleiter, einen keramischen Werkstoff oder einen metallischen Hartstoff umfasst.

Nachfolgend werden Beispiele für Verbundkörper 36 beschrieben, die zumindest eine funktionelle Schicht aufweisen oder zur weiteren Verwendung zur Herstellung eines elektronischen oder opto-elektronischen Bauelements 40, 42, 44 vorgesehen sind.

### Ausführungsbeispiel 1:

Das Substrat 34 ist amorph ausgebildet und besteht aus einer Fensterglasscheibe. Die funktionelle Schicht ist polykristallin ausgebildet und umfasst einen Verbindungshalbleiter, der aus Indiumzinnoxid (indium tin oxide, ITO) besteht und als integrierter Wärmeschutz der Fensterglasscheibe oder als transparente, elektrisch leitfähige Schicht dient.

In diesem Ausführungsbeispiel wird die ebene Substratoberfläche auf eine Temperatur von 100°C erwärmt. Das Terminieren der Substratoberfläche erfolgt durch Aufbringen von Stickstoff ("Nitridieren") aus der ersten Materialquelle 20 und einem eigens dafür hergestellten Plasma.

### Ausführungsbeispiel 2:

Für andere Verwendungen kann die polykristalline funktionelle Schicht andere Verbindungshalbleiter wie beispielsweise Indiumgalliumzinkoxid, Kupferindiumgalliumdiselenid oder Galliumnitrid umfassen und auf einem anderen Substrat 34 angeordnet werden, wobei das Substrat 34 des Verbundkörpers 36 der Verwendung angepasst ist und von amorphen oder polykristallinen Materialien wie Poly-Silizium, Kunststofffolie, Papier, Keramik und metallischen Wafern, zum Beispiel aus Wolframkupfer, gebildet sein kann.

### Ausführungsbeispiel 3:

Der in der Fig. 1 gezeigte Aufbau des als Schichtstruktur ausgebildeten Verbundkörpers 36 entspricht im Wesentlichen einem Aufbau von Verbundkörpern 36 zur weiteren Verwendung zur Herstellung eines elektronischen oder opto-elektronischen Bauelements 40, 42, 44, wobei das Substrat 34 der Verbundkörper 36 dieser Verwendung angepasst ist. In diesem Ausführungsbeispiel ist das Substrat 34 des Verbundkörpers 36 einkristallin ausgebildet und besteht aus Saphir.

In diesem Ausführungsbeispiel wird die ebene Substratoberfläche auf eine Temperatur von 500°C erwärmt.

Das Terminieren der Substratoberfläche nach einer Durchführung der Reinigung der Substratoberfläche erfolgt durch Aufbringen von Stickstoff ("Nitridieren") aus der ersten Materialquelle 20 und einem eigens dafür hergestellten Plasma. Das Aufwachsen der zumindest einen Schicht 38, die den Verbindungshalbleiter Aluminiumnitrid (AlN) umfasst, erfolgt durch Zuführen von Stickstoff als einer ersten Materialkomponente des Verbindungshalbleiters aus der ersten Materialquelle 20 und durch gleichzeitiges Zuführen von Aluminium aus einem festen Sputter-Target als einer zweiten Materialkomponente des Verbindungshalbleiters aus der zweiten Materialquelle 22 zu der Substratoberfläche.

### Ausführungsbeispiel 4:

In diesem Ausführungsbeispiel ist der Verbundkörper 36 ebenfalls zur weiteren Verwendung zur Herstellung eines elektronischen oder opto-elektronischen Bauelements 40, 42, 44 vorgesehen. Das Substrat 34 des Verbundkörpers 36 ist einkristallin ausgebildet und besteht aus Silizium, das verschiedene Orientierungen ((111), (110), (100)) aufweisen und On- oder Off-orientiert sein kann.

In diesem Ausführungsbeispiel wird die ebene Substratoberfläche auf eine Temperatur von 550°C erwärmt.

Das Terminieren der Substratoberfläche nach einer Durchführung der Reinigung der Substratoberfläche erfolgt durch Aufbringen von Kohlenstoff ("Carbonisieren") aus der ersten Materialquelle 20, der durch eine der ersten Gasleitungen 24 Methangas zugeführt wird, und einem eigens dafür hergestellten Plasma. Das Aufwachsen der zumindest einen Schicht 38, die den Verbindungshalbleiter Galiumnitrid (GaN) umfasst, erfolgt durch Zuführen von Stickstoff als einer ersten Materialkomponente des Verbindungshalbleiters aus der ersten Materialquelle 20 und durch gleichzeitiges Zuführen von Gallium aus einem festen Sputter-Target aus Galliumnitrid als einer zweiten Materialkomponente des Verbindungshalbleiters aus der zweiten Materialquelle 22 zu der Substratoberfläche.

### Ausführungsbeispiel 5:

in diesem Ausführungsbeispiel ist der Verbundkörper 36 ebenfalls zur weiteren Verwendung zur Herstellung eines elektronischen oder opto-elektronischen Bauelements 40, 42, 44 vorgesehen. Das Substrat 34 des Verbundkörpers 36 ist einkristallin ausgebildet und besteht aus Silizium.

In diesem Ausführungsbeispiel wird die ebene Substratoberfläche auf eine Temperatur von 450°C erwärmt.

Das Terminieren der Substratoberfläche nach einer Durchführung der Reinigung der Substratoberfläche erfolgt durch Aufbringen von Kohlenstoff ("Carbonisieren") aus der ersten Materialquelle 20, der durch eine der ersten Gasleitungen 24 Methangas zugeführt wird, und einem eigens dafür hergestellten Plasma. Das Aufwachsen der zumindest einen Schicht 38, die den Verbindungshalbleiter Aluminiumgaliumnitrid (AlGaN) umfasst, erfolgt durch Zuführen von Stickstoff als einer ersten Materialkomponente des Verbindungshalbleiters aus der ersten Materialquelle 20 und durch gleichzeitiges Zuführen von Aluminium und Gallium aus einem festen AlGaN-Sputtertarget als einer zweiten und dritten Materialkomponente des Verbindungshalbleiters aus der zweiten Materialquelle 22 zu der Substratoberfläche.

Das beschriebene Verfahren kann durch Aufbringen einer Mehrzahl von Halbleiter umfassenden Schichten 38 auf einen Verbundkörper 36 auch zur Herstellung eines elektronischen oder opto-elektronischen Bauelements 40, 42, 44 genutzt werden, in dem unter Verwendung eines hergestellten Verbundkörper 36 der Schritt des Aufwachsens einer Schicht 38, die zumindest einen Verbindungshalbleiter umfasst, mit den entsprechenden Materialkomponenten mehrfach wiederholt wird.

Die nach dem beschriebenen Verfahren hergestellten Verbundkörper 36 können alternativ dem Komplettsystem 10 entnommen und zur Herstellung der elektronischen und opto-elektronischen Bauelemente 40, 42, 44 zu anderen Herstellungsanlagen verbracht werden, wobei die Verbundkörper 36 während der Verbringung der normalen äußeren Atmosphäre ausgesetzt sein können. Die Herstellungsanlagen können dabei beispielsweise auf einem Verfahren beruhen, das aus einer Gruppe ausgewählt ist, die von metallorganischer chemischer Gasphasenabscheidung (MOCVD), Molekularstrahlepitaxie (MBE), oder Hydridgasphasenepitaxie (HVPE) gebildet ist.

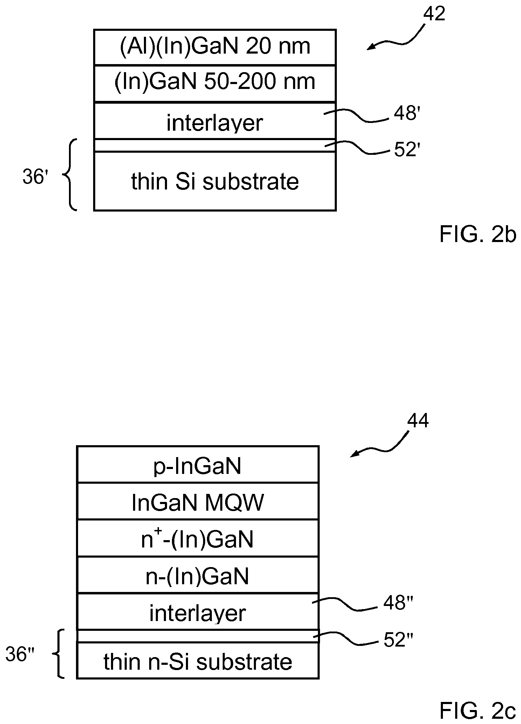

Fign. 2a-2c zeigen in stark schematisierter Weise elektronische und opto-elektronische Bauelemente 40, 42, 44, die unter Verwendung von Verbundkörpern 36 fertigbar sind, die mit einem erfindungsgemäßen Verfahren herstellbar sind, in schematischen Darstellungen. Die elektronischen und opto-elektronischen Bauelemente 40, 42, 44 sind als Solarzelle 40 (Fig. 2a), als HEMT 42 ("high electron-mobility transistor", Fig. 2b) und als LED 44 ("light-emitting diode", Fig. 2c) ausgestaltet.

In den Fig. 2a-2c ist der Typ jeder der Mehrzahl der Halbleiter umfassenden Schichten 38 bezeichnet. Eine Komponente eines Verbindungshalbleiters, die in Klammern gesetzt ist, soll als fakultativ verstanden werden. Hinweise zur Dotierung der Verbindungshalbleiter entsprechen der üblichen Vereinbarung. "MQW" (multi quantum well) ist die Bezeichnung für einen multiplen Quantentopf, der aus dem Stand der Technik bekannt ist und üblicherweise durch Anwendung des MOCVD-Verfahrens erzeugt wird.

Die in den Fig. 2a und 2c dargestellte Reihenfolge von Halbleiter umfassenden Schichten 38 beinhaltet ferner Zwischenschichten 48, 48', 48" (interlayers), die zur Verringerung von mechanischen Spannungen innerhalb des Verbundkörpers 36 dienen und zwischen den Halbleiter umfassenden Schichten 38 angeordnet und aus dem Stand der Technik bekannt sind.

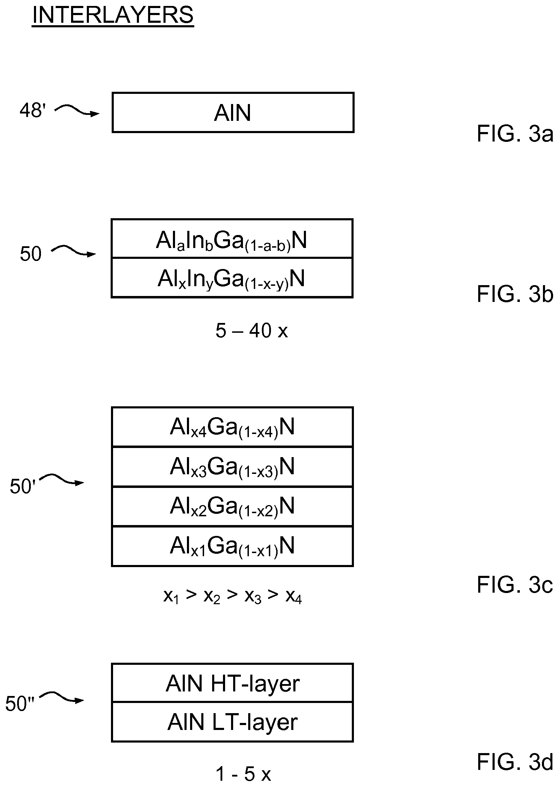

Beispielhafte Ausgestaltungen von Zwischenschichten 48, 50 sind in Figuren 3a-3d wiedergegeben. Die Fig. 3a zeigt eine Zwischenschicht 48', die aus einer einzelnen Schicht aus dem Verbindungshalbleiter Aluminiumnitrid (AlN) besteht.

Die Fig. 3b zeigt als Übergitterstruktur (superlattice) ausgebildete Zwischenschicht 50, bei der sich eine Folge von zwei Schichten aus dem Verbindungshalbleiter AlInGaN mit unterschiedlicher Konzentration der Komponenten Aluminium, Indium und Gallium wiederholt. Typischerweise beträgt die Anzahl der Wiederholungen der beiden Schichten zwischen fünf und 40.

In Fig. 3c ist eine Zwischenschicht 50' dargestellt, die als Gradientenstruktur des Verbindungshalbleiters Aluminiumgalliumnitrid (AlGaN) ausgebildet ist.

In der in Fig. 3d wiedergegebenen Ausführungsform einer Zwischenschicht 50" handelt es sich um eine Folge von zwei Schichten des Verbindungshalbleiters Aluminiumnitrid (AlN), wobei die untere Schicht bei einer niedrigeren Temperatur (LT: low temperature) der Waferplatte 32 hergestellt wurde als die obere Schicht (HT: high temperature).

### Bezugszeichenliste

- 10: Komplettsystem
- 12: Be- und Endladekammer
- 14: Übergabekammer
- 16: Vakuumschleuse
- 18: Reaktor
- 20: erste Materialquelle
- 22: zweite Materialquelle
- 24: erste Gasleitungen
- 26: zweite Gasleitungen
- 28: Heizvorrichtung
- 30: kapazitiv gekoppelte RF-Entladung
- 32: Waferplatte
- 34: Substrat
- 36: Verbundkörper
- 38: (Verbindungshalbleiter-)Schicht
- 40: elektronisches oder optoelektronisches Bauelement
- 42: elektronisches oder optoelektronisches Bauelement
- 44: elektronisches oder optoelektronisches Bauelement
- 46: Einheit
- 48: Zwischenschicht
- 50: Zwischenschicht
- 52: Terminierungsschicht

## Patentansprüche

1. Verfahren zur Herstellung eines Verbundkörpers (36) mit zumindest einer funktionellen Schicht oder zur weiteren Verwendung zur Herstellung eines elektronischen oder opto-elektronischen Bauelements (40, 42, 44), der Verbundkörper (36) als Schichtstruktur ausgebildet und umfassend:
- zumindest ein als Platte ausgebildetes Substrat (34) mit zumindest einer ebenen Substratoberfläche und
- zumindest eine im Wesentlichen polykristalline oder zumindest eine im Wesentlichen einkristalline Schicht (38), die zumindest einen Verbindungshalbleiter, einen keramischen Werkstoff oder einen metallischen Hartstoff umfasst, mit den folgenden Schritten:
- Erwärmung zumindest eines Teils der ebenen Substratoberfläche auf eine Temperatur von mindestens 100°C und höchstens 550°C;
- Reinigen der Substratoberfläche durch Zuführen von Wasserstoff aus einer ersten Materialquelle (20) und einem eigens dafür hergestellten Plasma;
- Terminieren der Substratoberfläche durch Aufbringen von Kohlenstoff, Stickstoff oder Sauerstoff aus der ersten Materialquelle (20) oder einer zweiten Materialquelle (22) und einem eigens dafür hergestellten Plasma; und
- Aufwachsen der zumindest einen Schicht (38) durch Zuführen von Materialkomponenten des Verbindungshalbleiters, des keramischen Werkstoffs oder des metallischen Hartstoffs aus der ersten Materialquelle (20) und der zweiten Materialquelle (22) zu der zumindest einen ebenen Substratoberfläche,
**dadurch gekennzeichnet, dass**
- ein Arbeitsdruck im Betrieb eines vakuumfähigen Reaktors (18), in dem die Schritte durchgeführt werden, zwischen 0.1 Pa und 10 Pa liegt und
- der Terminierungsschritt derart durchgeführt wird, dass durch das Terminieren eine Umwandlung des Substrats (34) in den obersten bis zu fünf Monolagen der Substratoberfläche bewirkt wird.

2. Verfahren nach Anspruch 1, **dadurch gekennzeichnet, dass** das Zuführen der Komponenten des Verbindungshalbleiters, des keramischen Werkstoffs oder des metallischen Hartstoffs mittels Kathodenzerstäubung, plasmaunterstützter chemischer Gasphasenabscheidung PECVD oder mittels zumindest einer lonenkanone erfolgt.

3. Verfahren nach Anspruch 1 oder 2, **dadurch gekennzeichnet, dass** das Zuführen der Komponenten des Verbindungshalbleiters, des keramischen Werkstoffs oder des metallischen Hartstoffs mittels einer Streifenquelle erfolgt.

4. Verfahren nach einem der vorhergehenden Ansprüche, **dadurch gekennzeichnet, dass** das Zuführen der Komponenten des Verbindungshalbleiters, des keramischen Werkstoffs oder des metallischen Hartstoffs mittels zumindest zweier unterschiedlicher Streifenquellen erfolgt, von denen zumindest eine Streifenquelle eine lonenkanone umfasst.

5. Verfahren nach einem der vorhergehenden Ansprüche, **dadurch gekennzeichnet, dass** das Substrat (34) zumindest während der Durchführung der Schritte des Terminierens und des Aufwachsens relativ zu zumindest einer der Materialquellen (20, 22) bewegt wird.

6. Verfahren nach einem der vorhergehenden Ansprüche, **dadurch gekennzeichnet dass** die Schritte in zumindest zwei unterschiedlichen vakuumfähigen Reaktoren (18) ausgeführt werden, wobei die Reaktoren (18) durch Vakuumschleusen (16) miteinander verbunden sind.

7. Verfahren zur Herstellung eines elektronischen oder opto-elektronischen Bauelements (40, 42, 44) durch Aufbringen einer Mehrzahl von Halbleiter umfassenden Schichten (38) auf einen Verbundkörper (36), **dadurch gekennzeichnet, dass** es ein Verfahren zur Herstellung des Verbundkörpers (36) nach einem der Ansprüche 1 bis 6 umfasst.

8. Verfahren zur Herstellung eines elektronischen oder opto-elektronischen Bauelements (40, 42, 44) nach Anspruch 7, **dadurch gekennzeichnet, dass** die Mehrzahl von Halbleiter umfassenden Schichten (38) Zwischenschichten (48, 50) umfasst, die zur Verringerung von mechanischen Spannungen innerhalb des Verbundkörpers (36) dienen.

9. Verwendung eines nach einem der Verfahren nach Anspruch 1 bis 6 herstellbaren Verbundkörpers (36) zur Herstellung eines elektronischen oder opto-elektronischen Bauelements (40, 42, 44) durch Aufbringen einer Mehrzahl Halbleiter umfassender Schichten (38) auf den Verbundkörper (36).

10. Verwendung nach Anspruch 9, **dadurch gekennzeichnet, dass** die Mehrzahl von Schichten (38) Zwischenschichten (48, 50) umfasst, die zur Verringerung von mechanischen Spannungen innerhalb des Verbundkörpers (36) dienen.

11. Verwendung nach Anspruch 9 oder 10, **dadurch gekennzeichnet, dass** das Aufbringen der Mehrzahl Halbleiter umfassender Schichten (38) durch ein Verfahren erfolgt, das aus einer Gruppe ausgewählt ist, die von metallorganischer chemischer Gasphasenabscheidung MOCVD, Molekularstrahlepitaxie MBE, oder Hydridgasphasenepitaxie HVPE gebildet ist.

12. Verbundkörper (36) mit zumindest einer funktionellen Schicht oder zur weiteren Verwendung zur Herstellung eines elektronischen oder opto-elektronischen Bauelements (40, 42, 44), der Verbundkörper (36) als Schichtstruktur ausgebildet und umfassend:
- zumindest ein als Platte ausgebildetes Substrat (34) mit zumindest einer ebenen Substratoberfläche und
- zumindest eine im Wesentlichen polykristalline oder zumindest eine im Wesentlichen einkristalline Schicht (38), die zumindest einen Verbindungshalbleiter, einen keramischen Werkstoff oder einen metallischen Hartstoff umfasst,
**dadurch gekennzeichnet, dass** der Verbundkörper (36)
- mittels eines der Verfahren nach einem der Ansprüche 1 bis 6 herstellbar ist und
- eine Terminierungsschicht (52) aufweist, die durch eine mittels Terminieren bewirkte Umwandlung des Substrats (34) in den obersten bis zu fünf Monolagen der ebenen Substratoberfläche erstellt ist.

13. Elektronisches oder opto-elektronisches Bauelement (40, 42, 44) mit zumindest einem Verbundkörper (36) nach Anspruch 12,
**dadurch gekennzeichnet, dass** das elektronische oder opto-elektronische Bauelement (40, 42, 44) mittels eines der Verfahren nach einem der Ansprüche 7 oder 8 herstellbar ist.

## Claims

1. Method for producing a composite body (36) comprising at least one functional layer or for further use for producing an electronic or opto-electronic device (40, 42, 44), wherein the composite body (36) is formed as a layered structure and comprises:
at least one substrate (34) formed as a plate comprising at least one planar substrate surface; and
at least one substantially polycrystalline or at least one substantially monocrystalline layer (38) which comprises at least one compound semiconductor, a ceramic material or a metallic hard material,
comprising the following steps:
heating at least a portion of the planar substrate surface to a temperature of at least 100°C and at most 550°C;
cleaning the substrate surface by supplying hydrogen from a first material source (20) and a plasma specifically prepared therefor;
terminating the substrate surface by depositing carbon, nitrogen or oxygen from the first material source (20) or a second material source (22) and a plasma specifically prepared therefor; and
growing the at least one layer (38) by supplying material components of the compound semiconductor, the ceramic material or the metallic hard material from the first material source (20) and the second material source (22) to the at least one planar substrate surface;
**characterized in that**
a working pressure during the operation of a vacuum-capable reactor (18), in which the steps are carried out, is between 0.1 Pa and 10 Pa; and
the termination step is carried out such that the terminating step causes a conversion of the substrate (34) in the uppermost up to five monolayers of the substrate surface.

2. Method according to claim 1, **characterized in that** the supply of the components of the compound semiconductor, the ceramic material or the metallic hard material is implemented by means of sputtering, plasma enhanced chemical vapor deposition PECVD or by means of at least one ion gun.

3. Method according to claim 1 or 2, **characterized in that** the supply of the components of the compound semiconductor, the ceramic material or the metallic hard material is implemented by means of a strip source.

4. Method according to any one of the preceding claims, **characterized in that** the supply of the components of the compound semiconductor, the ceramic material or the metallic hard material is implemented by means of at least two different strip sources, wherein at least one strip source comprises an ion gun.

5. Method according to any one of the preceding claims, **characterized in that** the substrate (34) is moved relative to at least one of the material sources (20, 22) at least during the terminating and growing steps.

6. Method according to any one of the preceding claims, **characterized in that** the steps are carried out in at least two different vacuum-capable reactors (18), wherein the reactors (18) are connected to each other by vacuum locks (16).

7. Method of producing an electronic or opto-electronic device (40, 42, 44) by depositing a plurality of layers (38) comprising semiconductors onto a composite body (36), **characterized in that** it comprises a method for producing the composite body (36) according to any one of claims 1 to 6.

8. Method for producing an electronic or opto-electronic device (40, 42, 44) according to claim 7, **characterized in that** the plurality of layers (38) comprising semiconductors include intermediate layers (48, 50), which serve to reduce mechanical stresses within the composite body (36).

9. Use of a composite body (36) producible according to a method according to any one of claim 1 to 6 for producing an electronic or optoelectronic device (40, 42, 44) by depositing a plurality of layers (38) comprising semiconductors onto the composite body (36).

10. Use according to claim 9, **characterized in that** the plurality of layers (38) comprise intermediate layers (48, 50) which serve to reduce mechanical stresses within the composite body (36).

11. Use according to claim 9 or 10, **characterized in that** the deposition of the plurality of layers (38) comprising semiconductors is carried out by a method selected from the group consisting of metalorganic chemical vapor deposition MOCVD, molecular beam epitaxy MBE or hydride gas phase epitaxy HVPE.

12. Composite body (36) comprising at least one functional layer or for further use for producing an electronic or opto-electronic device (40, 42, 44), wherein the composite body (36) is formed as a layered structure and comprises:
at least one substrate (34) formed as a plate comprising at least one planar substrate surface; and
at least one substantially polycrystalline or at least one substantially monocrystalline layer (38) which comprises at least one compound semiconductor, a ceramic material or a metallic hard material,
**characterized in that** the composite body (36)
can be produced by means of a method according to any one of claims 1 to 6; and
comprises a termination layer (52), which is formed by conversion of the substrate (34) in the uppermost up to five monolayers of the planar substrate surface caused by means of termination.

13. Electronic or opto-electronic device (40, 42, 44) comprising at least one composite body (36) according to claim 12,
**characterized in that** the electronic or opto-electronic device (40, 42, 44) can be produced by means of a method according to claim 7 or 8.

## Revendications

1. Procédé de production d'un corps composite (36) comportant au moins une couche fonctionnelle ou pour une utilisation ultérieure pour une production d'un composant électronique ou optoélectronique (40, 42, 44), le corps composite (36) étant sous forme de structure en couches et comprenant :
- au moins un substrat (34) sous forme de plaque comportant au moins une surface de substrat plane et
- au moins une couche essentiellement polycristalline ou au moins une couche essentiellement monocristalline (38) comprenant au moins un semi-conducteur composé, un matériau céramique ou un matériau dur métallique,
le procédé comportant les étapes suivantes :
- un réchauffement d'au moins une partie de la surface de substrat plane à une température d'au moins 100°C jusqu'au maximum de 550°C ;
- un nettoyage de la surface de substrat plane par alimentation en hydrogène d'une première source de matériau (20) et d'un plasma produit à cet effet ;
- un finissage de la surface de substrat plane en apportant du carbone, de l'azote ou de l'oxygène de la première source de matériau (20) ou d'une deuxième source de matériau (22) et d'un plasma produit à cet effet ; et
- une croissance de l'au moins une couche (38) par alimentation en composants de matériau du semi-conducteur composé, du matériau céramique ou du matériau dur métallique de la première source de matériau (20) et de la deuxième source de matériau (22) à l'au moins une surface de substrat plane, **caractérisé en ce que**
- une pression de travail au cours du fonctionnement d'un réacteur (18) capable d'opérer sous vide, dans lequel les étapes sont effectuées, se situe entre 0,1 Pa et 10 Pa ;
- l'étape de finissage est effectuée de sorte qu'une transformation du substrat (34) est obtenue par le finissage dans la monocouche supérieure et jusqu'à cinq monocouches de la surface du substrat.

2. Procédé selon la revendication 1, **caractérisé en ce que** l'alimentation en composants de matériau du semi-conducteur composé, du matériau céramique ou du matériau dur métallique est effectuée au moyen d'une pulvérisation cathodique, d'un dépôt chimique en phase vapeur assisté par plasma PECVD ou au moyen d'au moins un canon à ions.

3. Procédé selon la revendication 1 ou la revendication 2, **caractérisé en ce que** l'alimentation en composants de matériau du semi-conducteur composé, du matériau céramique ou du matériau dur métallique est effectuée au moyen d'une source de raies.

4. Procédé selon l'une quelconque des revendications précédentes, **caractérisé en ce que** l'alimentation en composants de matériau du semi-conducteur composé, du matériau céramique ou du matériau dur métallique est effectuée au moyen d'au moins deux sources de raies différentes, dont au moins une est un canon à ions.

5. Procédé selon l'une quelconque des revendications précédentes, **caractérisé en ce que** le substrat (34) est mû au moins pendant la réalisation des étapes de finissage et de croissance relativement à au moins une des sources de matériau (20, 22).

6. Procédé selon l'une quelconque des revendications précédentes, **caractérisé en ce que** les étapes sont effectuées dans au moins deux réacteurs capables d'opérer sous vide (18), les réacteurs (18) étant connectés l'un à l'autre au moyen de sas sous vide (16).

7. Procédé de production d'un composant électronique ou optoélectronique (40, 42, 44) par application d'une pluralité de couches (38) comprenant des semi-conducteurs sur un corps composite (36), **caractérisé en ce que** le procédé comprend un procédé de production du corps composite (36) selon l'une quelconque des revendications 1 à 6.

8. Procédé de production d'un composant électronique ou optoélectronique (40, 42, 44) selon la revendication 7, **caractérisé en ce que** la pluralité de couches (38) comprenant des semi-conducteurs comprend des couches intermédiaires (48, 50) qui servent à réduire les tensions mécaniques à l'intérieur du corps composite (36).

9. Utilisation d'un corps composite (36) apte à être produit selon un des procédés des revendications 1 à 6 pour la production d'un composant électronique ou optoélectronique (40, 42, 44) par application d'une pluralité de couches (38) comprenant des semi-conducteurs sur le corps composite (36).

10. Utilisation selon la revendication 9, **caractérisée en ce que** la pluralité de couches (38) comprend des couches intermédiaires (48, 50) qui servent à réduire les tensions mécaniques à l'intérieur du corps composite (36).

11. Utilisation selon la revendication 9 ou la revendication 10, **caractérisée en ce que** l'application d'une pluralité de couches (38) comprenant des semi-conducteurs est effectuée au moyen d'un procédé sélectionné parmi le groupe constitué de lépitaxie en phase vapeur aux organométalliques MOCVD, l'épitaxie par jets moléculaires MBE ou l'épitaxie en phase vapeur aux hydrures HVPE.

12. Corps composite (36) comportant au moins une couche fonctionnelle ou pour une utilisation ultérieure pour une production d'un composant électronique ou optoélectronique (40, 42, 44), le corps composite (36) étant sous forme de structure en couches et comprenant :
- au moins un substrat (34) sous forme de plaque comportant au moins une surface de substrat plane et
- au moins une couche essentiellement polycristalline ou au moins une couche essentiellement monocristalline (38) comprenant au moins un semi-conducteur composé, un matériau céramique ou un matériau dur métallique,
**caractérisé en ce que** le corps composite (36)
- est apte à être produit au moyen du procédé selon l'une quelconque des revendications 1 à 6 et
- comprend une couche de finissage (52) qui est réalisée au moyen d'une transformation du substrat (34) obtenue par un finissage dans la monocouche supérieure et jusqu'à cinq monocouches de la surface du substrat plane.

13. Composant électronique ou optoélectronique (40, 42, 44) comportant au moins un corps composite (36) selon la revendication 12, **caractérisé en ce que** le composant électronique ou optoélectronique (40, 42, 44) est apte à être réalisé au moyen du procédé selon l'une quelconque des revendications 7 ou 8.
